# EUROPEAN PATENT APPLICATION

(11) **EP 1 956 661 A1**
(43) Date of publication of application: **13.08.2008**
(21) Application number: 06833549.6
(22) Date of filing: 28.11.2006
(51) Int. Cl.: H01L 31/042, C08J 3/22

(54) **FILLER FOR SOLAR CELL MODULE, SOLAR CELL MODULE USING SAME, AND METHOD FOR PRODUCING FILLER FOR SOLAR CELL MODULE**

(30) Priority: 29.11.2005 JP 2005344050
(71) Applicant: Dai Nippon Printing Co., Ltd., Tokyo 162-8001 (JP); Sanyo Electric Co., Ltd., Osaka 570-8677 (JP)
(72) Inventor: OOI, Kasumi, Shinjuku-ku, Tokyo 1628001 (JP); TSUZUKI, Atsuo, Shinjuku-ku, Tokyo 1628001 (JP); HAYASHI, Katsuhiko, Shinjuku-ku, Tokyo 1628001 (JP); OKAMOTO, Shigeyuki, Moriguchi-shi, Osaka 5708677 (JP); YOSHIMINE, Yukihiro, Moriguchi-shi, Osaka 5708677 (JP); MARUYAMA, Eiji, Moriguchi-shi, Osaka 5708677 (JP)
(74) Representative: Smart, Peter John
(86) International application number: PCT/JP2006/323745
(87) International publication number: WO 2007/063861

(57) **Abstract**

A main object of the present invention is to provide an encapsulant for a photovoltaic module, which may inhibit the encapsulant from clouding when a hot spot phenomenon is caused. To attain the object, the invention provides an encapsulant for a photovoltaic module comprising: a resin for an encapsulant containing a silane-modified resin obtained by polymerizing an ethylenically unsaturated silane compound and polyethylene for polymerization; and a master batch containing a UV-absorbent, a light stabilizer, a thermal stabilizer and polyethylene for use in a master batch, **characterized in that** the polyethylene for polymerization and the polyethylene for use in a master batch are metallocene based linear low density polyethylene having a density in the range of 0.895 g/cm³ to 0.910 g/cm³.

## Description

### TECHNICAL FIELD

The invention relates to an encapsulant for a photovoltaic module which is difficult to be clouded even when a temperature change is caused owing to a phenomenon such as a hot spot phenomenon.

### BACKGROUND ART

In recent years, attention has been paid to a photovoltaic cell as a clean energy source in light of the increasing awareness of environmental issues.
In many cases, a photovoltaic cell device is prepared by use of a single crystal silicon substrate or a polycrystalline silicon substrate. Accordingly, a photovoltaic cell device is weak to physical impact and, it has to be protected against weather conditions such as rain when installed out of doors. Furthermore, since one sheet of photovoltaic cell device is small in electrical output, a plurality of photovoltaic cell devices has to be connected in series parallel to enable to take out practical electric output. Accordingly, usually, a plurality of photovoltaic cell devices is connected and encapsulated by use of transparent substrates and an encapsulant to prepare a photovoltaic module. The photovoltaic module is generally produced by laminating members such as a transparent front substrate, an encapsulant, a photovoltaic cell device, an encapsulant, and a back surface protective sheet in this order and then thermally pressure-bonding them by vacuum suction in such as a lamination method.

As the encapsulant for a photovoltaic module, ethylene-vinyl acetate copolymer resins (EVA) have most commonly been used in terms of the processibility, layering workability, production cost, and so forth. However, the encapsulant made of an ethylene-vinyl acetate copolymer resin is not necessarily sufficient in the adhesion strength to the photovoltaic cell device and has a problem that the disadvantageous weaknesses, such as peelings caused in the long time use in outdoors, or generation of acetic acid gas when heated and giving out off-odor or forming foam, become apparent. Therefore, a method of polymerizing a silane compound with a resin is employed as a method for providing the encapsulant with adhesive properties and for preventing the generation of acetic acid gas (see Patent Documents 1 and 2).

In an photovoltaic module installed out of doors, when, among a plurality of photovoltaic cell devices of an photovoltaic module during power generation, one photovoltaic cell device becomes incapable of sufficiently generating electricity for any reason such as being placed in the shade of an object, the photovoltaic cell device becomes resistance. At this time, to both electrodes of the photovoltaic cell device, a potential difference which is a product of the resistance value and a flowing current is generated. That is, a bias voltage is applied to the photovoltaic cell device in a reverse direction, resulting in causing heat generation in the photovoltaic cell device. Such a phenomenon is called the hot spot.

When the hot spot phenomenon is caused and a temperature of a photovoltaic cell device is elevated, a temperature of an encapsulant goes up together therewith. In the case where a polyethylene based resin is used as an encapsulant, when a temperature change is caused exceeding a melting point of the encapsulant, at the time when the polyethylene based resin is once melted and solidified once more, the polyethylene based resin is partially crystallized and clouded, thereby the appearance is largely damaged.

As a method that inhibits a temperature of an photovoltaic module from going up when the hot spot phenomenon is caused, methods of providing a film having an irregular surface and high in the thermal emissivity on both surfaces of the photovoltaic cell device, and of providing a ventilating hole to a module frame disposed around a photovoltaic cell device are proposed (see Patent Document 3). Furthermore, another method is proposed wherein particles such as alumina or zirconia that makes the thermal conductivity larger are added to a backside encapsulant to improve the thermal conductivity inside of the photovoltaic module to inhibit a temperature of the photovoltaic cell device from going up even when the hot spot phenomenon is caused (see Patent Document 4). When a temperature of the photovoltaic module or photovoltaic cell device is inhibited from going up, a temperature of the encapsulant is inhibited from going up as a result; accordingly, it is considered that the encapsulant is inhibited from clouding. However, none of the Patent Documents mentions about inhibiting the encapsulant from clouding caused by generation of the hot spot phenomenon.

Furthermore, as mentioned above, an ethylene-vinyl acetate copolymer is mainly used as conventional encapsulant. At present, there is no proposition found which inhibits an encapsulant from clouding, wherein a copolymer resin excellent in the adhesiveness is used and the copolymer resin is one in which a silane compound is polymerized to a resin.

Patent Document 1: Japanese Patent Application Publication No. 62-14111
Patent Document 2: Japanese Patent Application Laid-Open No. 2004-214641
Patent Document 3: Japanese Patent Application Laid-Open No. 06-181333
Patent Document 4: Japanese Patent Application Laid-Open No. 2004-327630

### DISCLOSURE OF THE INVENTION

### PROBLEM TO BE SOLVED BY THE INVENTION

The invention was carried out in view of the situations and a main object thereof is to provide an encapsulant for a photovoltaic module, which can inhibit the encapsulant from clouding when a hot spot phenomenon is caused.

### MEANS FOR SOLVING THE PROBLEM

To attain the above-mentioned object, the present invention provides an encapsulant for a photovoltaic module comprising: a resin for an encapsulant containing a silane-modified resin obtained by polymerizing an ethylenically unsaturated silane compound and polyethylene for polymerization; and a master batch containing a UV-absorbent, a light stabilizer, a thermal stabilizer and polyethylene for use in a master batch, characterized in that the polyethylene for polymerization and the polyethylene for use in a master batch are metallocene based linear low density polyethylene having a density in the range of 0.895 g/cm³ to 0.910 g/cm³.

According to the invention, since the densities of polyethylene for polymerization and master batch polyethylene are relatively low, even when a temperature change caused by the hot spot phenomenon or the like is occurred, the polyethylene is inhibited from crystallizing; accordingly, the encapsulant is inhibited from clouding.

Further, in the invention, when the encapsulant for a photovoltaic module is formed into a sheet having a thickness set at 600 ± 15 µm, a peak area in the range of a wavelength of 6000 nm or more and 25000 nm or less is preferably 12000 or less.
According to the Planck's law, when a cell receives heat corresponding to from several tens to one hundred and several tens °C due to solar heat or the hot spot phenomenon, a wavelength distribution of heat considered radiated from the cell is contained in the range of about 6000 nm to 25000 nm. When a temperature of a photovoltaic cell device goes up due to radiation heat of solar light or heat generated when a photovoltaic cell generates electricity, the power generation efficiency is deteriorated in some cases because of the temperature characteristics. However, when a peak area in about 6000 nm to 25000 nm is low, the encapsulant becomes a material low in the thermal absorptivity. In the case where a temperature of the photovoltaic cell device goes up due to radiation heat of solar light or heat generated when a photovoltaic cell generates electricity, the power generation efficiency may be inhibited from deteriorating because of the temperature characteristics. Furthermore, since the encapsulant becomes difficult to store heat generated due to the hot pot phenomenon or the like, the encapsulant is inhibited from clouding and thereby the appearance is inhibited from deteriorating.

The present invention further provides an photovoltaic module comprising an encapsulant layer using the above-mentioned encapsulant for a photovoltaic module.

According to the invention, because an encapsulant layer uses the above-mentioned encapsulant for photovoltaic module, the encapsulant layer is made excellent in the adhesiveness with a transparent front substrate and a photovoltaic cell device and beautiful in the appearance.

### EFFECT OF THE INVENTION

In the invention, since the respective densities of polyethylene for polymerization and master batch polyethylene contained in an encapsulant for photovoltaic module are relatively low, even when a temperature change due to the hot spot phenomenon or the like is caused, the encapsulant can attain an effect of being inhibited from clouding.

### BRIEF DESCRIPTION OF THE DRAWINGS

FIG. 1 is a schematic cross-sectional view showing one example of a photovoltaic module of the invention.
FIG. 2 shows an infrared absorption spectrum of an encapsulant for a photovoltaic module of Example 1.

### EXPLANATION OF REFERENCES

- 1: Photovoltaic cell device
- 2: Wiring electrode
- 3: Take-out electrode
- 4a: Front side encapsulant layer
- 4b: Backside encapsulant layer
- 5: Transparent front substrate
- 6: Back surface protective sheet
- T: Photovoltaic module

### BEST MODE FOR CARRYING OUT THE INVENTION

In what follows, an encapsulant for a photovoltaic module of the present invention, a photovoltaic module using the same and a producing method of an encapsulant for a photovoltaic module will be described.

### A. Encapsulant for Photovoltaic module

First, an encapsulant for a photovoltaic module of the present invention will be explained. The encapsulant for a photovoltaic module of the present invention comprises: a resin for a encapsulant containing a silane-modified resin obtained by polymerizing an ethylenically unsaturated silane compound and polyethylene for polymerization; and a master batch containing a UV-absorbent, a light stabilizer, a thermal stabilizer and polyethylene for use in a master batch, characterized in that the polyethylene for polymerization and the polyethylene for use in a master batch are metallocene based linear low density polyethylene having a density in the range of 0.895 to 0.910 g/cm³.

According to the invention, since the respective densities of polyethylene for polymerization and master batch polyethylene are relatively low, even when a temperature change is caused such that a temperature goes up due to heat generated by the hot spot phenomenon or the like, followed by cooling due to a temperature decrease in an external temperature, the polyethylene is inhibited from crystallizing; accordingly, the encapsulant is inhibited from clouding. As the result, the haze (degree of cloudiness generated) when temperature of an encapsulant for a photovoltaic module of which is raised and subsequently cooled is inhibited from going up; accordingly, the haze variation caused by temperature change becomes less and an encapsulant for photovoltaic module, which is difficult to be damaged in the appearance can be obtained.

Furthermore, in the invention, as the polyethylene for polymerization and master batch polyethylene,metallocene based linear low density polyethylene is used. The metallocene based linear low density polyethylene is polymerized by use of a metallocene catalyst which is a single site catalyst and known to be small in a molecular weight distribution. In the invention, when polyethylene that is small in the molecular weight distribution and low in the density is used, the encapsulant is inhibited from clouding. That is, in the case where a temperature goes up due to heat generated by the hot spot phenomenon or the like, followed by cooling due to a temperature decrease in an external temperature, when polyethylene large in the molecular weight distribution and high in the density is used, it is considered that polyethylene that is high in the melting point and readily crystallized crystallizes in advance to form a nucleus to readily cause the clouding of the encapsulant. However, when polyethylene that is small in the molecular weight distribution and low in the density such as the metallocene based linear low density polyethylene is used, the encapsulant is inhibited from clouding.

Furthermore, since a silane modified resin contained in the resin for the encapsulant in the invention is, as mentioned above, excellent in the adhesiveness with a transparent front substrate or a back surface protective sheet such as glass and, since a main chain thereof is made of polyethylene, the silane modified resin does not generate a detrimental gas; accordingly, it is advantageous in that the working environment is not deteriorated.

Still furthermore, since the encapsulant of the invention for a photovoltaic module contains a UV-absorbent, a light stabilizer and a thermal stabilizer, the mechanical strength, the adhesive force, yellowing inhibition, crack inhibition and excellent workability are stably obtained over a long term.
In what follows, the respective constituents of the encapsulant of the invention for a photovoltaic module will be described.

### 1. Resin for Encapsulant

First, a resin for an encapsulant used in the invention will be described. The resin for an encapsulant used in the invention includes a silane-modified compound obtained by polymerizing an ethylenically unsaturated silane compound and predetermined polyethylene for polymerization. Furthermore, the resin for an encapsulant preferably contains polyethylene for addition as needs arise. Since the silane-modified resin is expensive, a combinatory use of the polyethylene for addition enables to reduce the cost.
In what follows, a silane-modified resin and polyethylene for addition contained in the resin for an encapsulant and other points of the resin for an encapsulant will be described.

### (1) Silane-modified Resin

The silane-modified resin contained in the resin for an encapsulant in the invention is obtained by polymerizing an ethylenically unsaturated silane compound and predetermined polyethylene for polymerization. Such silane-modified resin can be obtained by a method, for instance, wherein an ethylenically unsaturated silane compound, polyethylene for polymerization and a radical initiator are mixed, melted and kneaded at high temperature to graft polymerize the ethylenically unsaturated silane compound to the polyethylene for polymerization.

In the invention, as the polyethylene for polymerization, metallocene based linear low density polyethylene having the density in the range of 0.895 to 0.910 g/cm³ is used. Such metallocene based linear low density polyethylene is relatively low in the density and small in the molecular weight distribution; accordingly, the polyethylene is inhibited from crystallizing caused by temperature change and thereby the encapsulant is inhibited from clouding.

Furthermore, the polyethylene for polymerization has the density in the range of 0.895 to 0.910 g/cm³ as mentioned above. In particular, the density is preferably in the range of 0.898 to 0.905 g/cm³.

As such polyethylene for polymerization, as far as it is linear polyethylene synthesized by use of a metallocene catalyst and has the density mentioned above, general metallocene based linear low density polyethylene can be used without restriction. Furthermore, the polyethylene for polymerization may be used singularly or in a combination of at least two kinds thereof.

On the other hand, as for the ethylenically unsaturated silane compound used for the silane-modified resin, it is not particularly limited as long as it graft-polymerized with the polyethylene for polymerization. For example, one or more out of the following can be used: vinyltrimethoxysilane, vinyltriethoxysilane, vinyltripropoxysilane, vinyltriisopropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinypropionyloxysilane, vinyltriacetoxysilane, or vinyltricarboxysilane. Vinyltrimethoxysilane is preferably used in the present invention.

The amount of the ethylenically unsaturated silane compound in the encapsulant for a photovoltaic module of the present invention is preferably 10 ppm or more and further preferably 20 ppm or more. In the present invention, by using the ethylenically unsaturated silane compound polymerized with the above-mentioned polyethylene for polymerization, good adhesion properties to a material such as glass, to be employed for the transparent front substrate and the back surface sheet for a photovoltaic module can be provided. Accordingly, if the amount of the ethylenically unsaturated silane compound is less than the above range, the adhesion properties to a material such as glass become insufficient.
The amount of the ethylenically unsaturated silane compound is preferably 4000 ppm or less and further preferably 3000 ppm or less. The upper limit is not limited in terms of the adhesion properties to a material such as glass, if it exceeds the above-mentioned range, the cost is increased although the adhesion property to glass is not changed.

It is preferable for the above-mentioned silane-modified resin to be contained in a range of 1 to 80% by weight in the encapsulant layer for a photovoltaic module and it is more preferable in a range of 5 to 70% by weight. The encapsulant layer for a photovoltaic module has high adhesion properties to glass since it contains the silane-modified resin as described above. Consequently, in terms of the adhesion properties to a material such as glass and the cost, the silane-modified resin is used preferably in the above-mentioned range.

The silane-modified resin has a melt mass flow rate at 190°C preferably in a range of 0.5 to 10 g/10 minute and more preferably in a range of 1 to 8 g/10 minute. It is because the formability of the encapsulant layer for a photovoltaic module and the adhesion properties and the like to the transparent front substrate and the backside protective sheet are made excellent.
The melting point of the silane-modified resin is preferably 110°C or lower. At the time of producing a photovoltaic module using the encapsulant for a photovoltaic module of the present invention, the above-mentioned range is preferable in terms of the aspects such as processibility. A melting point measurement method is carried out by differential scanning calorimetry (DSC) according to the measurement method of transition temperature of plastics (JISK 7121). In this connection, when two or more melting points exist, the higher temperature is defined to be the melting point.

Examples of a radical initiator to be added to the silane-modified resin are organic peroxides, e.g. hydroperoxides such as diisopropylbenzene hydroxyperoxide and 2,5-dimethyl-2,5-di(hydroperoxy)hexane; dialkylperoxides such as di-tert-butyl peroxide, tert-butylcumyl peroxide, dicumyl peroxide, 2,5-dimethyl-2,5-di(tert-butylperoxy)hexane, and 2,5-dimethyl-2,5-di(tert-peroxy)hexyn-3; diacyl peroxides such as bis(3,5,5-trimethylhexanoyl)peroxide, octanoyl peroxide, benzoyl peroxide, o-methylbenzoyl peroxide, and 2,4-dichlorobenzoyl peroxide; peroxy esters such as tert-butylperoxy acetate,tert-butylperoxy-2-ethylhexanoate, tert-butylperoxy pyvalate, tert-butylperoxy octoate, tert-butylperoxyisopropyl carbonate, tert-butylperoxy benzoate, di-tert-butylperoxy phthalate, 2,5-dimethyl-2,5-di(benzoylperoxy)hexane, and 2,5-dimethyl-2,5-di(benzoylperoxy)hexyn-3; and ketone peroxides such as methyl ethyl ketone peroxide and cyclohexanone peroxide; and azo compounds such as azobis(isobutyronitrile) and azobis(2,4-dimethylvaleronitrile).

The used amount of the radical initiator is preferable to be added in an amount of 0.001% by weight or more in the silane-modified resin. This is because, if it is less than the above-mentioned range, the radical polymerization of the ethylenic unsaturated silane compound and the polyethylene for polymerization is difficult to be caused.

The silane-modified resin to be used in the invention may be used for laminate glass. The laminate glass is produced by sandwiching a soft and tough resin or the like between glass plates and thermally pressure bonding the plates. Therefore, in terms of the adhesion properties to glass, the above-mentioned silane-modified resin can be used.

Furthermore, a method of preparing the silane-modified resin is not restricted particularly. For instance, a method where a mixture of an ethylenically unsaturated silane compound, polyethylene for polymerization and a radical initiator is heated, melted and mixed to graft polymerize the ethylenically unsaturated silane compound to polyethylene for polymerization is cited. At that time, a heating temperature is preferably 300°C or less, more preferably 270°C or less and most preferably 230°C or less.

### (2) Polyethylene for Addition

In the next place, polyethylene for addition used in the invention will be described. As mentioned above, the resin for an encapsulant preferably contains polyethylene for addition as needs arise. As the polyethylene for addition, specifically, one same as the polyethylene for polymerization used in the silane-modified resin, that is, a metallocene based linear low density polyethylene having the density in the range of 0.895 to 0.910 g/cm³ is cited. In the invention, in particular, the polyethylene for addition is preferably polyethylene same as the polyethylene for polymerization.

The content of the polyethylene for addition is preferably 0. 01 part by weight to 9, 900 parts by weight and more preferably 90 parts by weight to 9,900 parts by weight to the silane-modified resin 100 parts by weight. When two or more kinds of the silane-modified resins are used, the content of the polyethylene for addition is preferable to be in the above-mentioned range to the resins 100 parts by weight in total.

The polyethylene for addition is preferable to have a melt mass flow rate at 190°C in a range of 0.5 to 10 g/10 minute and more preferable to have it in a range of 1 to 8 g/10 minute. It is because properties such as formability of the encapsulant for a photovoltaic module become excellent.
Furthermore, a melting point of the polyethylene for addition is preferably 130°C or less. From the viewpoint of the workability at the time of producing a photovoltaic module that uses an encapsulant for a photovoltaic module of the invention, the foregoing range is preferred. The melting point is one obtained by use of a method mentioned above.

### (3) Others

The resin for an encapsulant used in the present intention is preferable to have a melt mass flow rate at 190°C in a range of 0.5 to 10 g/10 minute and more preferable to have it in a range of 1 to 8 g/10 minute. It is because properties such as formability of the encapsulant for a photovoltaic module and adhesion properties to the transparent front substrate and the back surface protective sheet become excellent.
Furthermore, a melting point of the resin for an encapsulant is preferably 130°C or less. From the viewpoint of the workability at the time of producing a photovoltaic module that uses an encapsulant for a photovoltaic module of the invention, the foregoing range is preferred. It is preferable also because reusing of a constituent member for the photovoltaic module such as the photovoltaic cell device or the transparent front substrate is easy if the melting point is in the above degree. The melting point is one obtained by use of a method mentioned above.

### 2. Master Batch

Next, a master batch used in the invention will be described. A master batch used in the invention contains a UV-absorbent, a light stabilizer, a thermal stabilizer and polyethylene for use in a master batch.
In what follows, polyethylene for use in a master batch, a UV-absorbent, a light stabilizer and a thermal stabilizer, which are contained in the master batch, will be described.

### (1) Polyethylene for Use in a Master Batch

First, the polyethylene for use in a master batch used in the invention will be explained. In the invention, as the polyethylene for use in a master batch, metallocene based linear low density polyethylene having the density in the range of 0.895 to 0.910 g/cm³ is used. Such the metallocene based linear low density polyethylene is relatively low in the density and small in the molecular weight distribution; accordingly, the polyethylene is inhibited from crystallizing caused by temperature change and thereby the encapsulant is inhibited from clouding.

As the polyethylene for use in a master batch, those described in "1. Resin for a Fiiler" mentioned above can be used; accordingly the description is omitted here.

### (2) UV absorbent

Next, the UV absorbent used in the present invention will be explained. The UV absorbent used in the invention is an agent for absorbing harmful ultraviolet rays in the sun light and converting the ultraviolet rays into harmless heat energy in the molecules and accordingly preventing excitation of the active species which initiate photo-deterioration in the encapsulant for a photovoltaic module. Specifically, inorganic type UV absorbents selected from a group of consisting of benzophenone type, benzotriazole type, salicylate type, acrylonitrile type, metal complex salt type, hindered amine type ultraviolet absorbents, ultra fine particles of titanium oxide (particle diameter: 0.01 µm to 0.06 µm), and ultra fine particles of zinc oxide (particle diameter: 0.01 µm to 0.04 µm) can be used.

A content of a UV-absorbent in an encapsulant for a photovoltaic module is, though depends on factors such as a particle shape and the density, preferably in the range of 0.075 to 0.3% by weight and more preferably in the range of 0.1 to 0.2% by weight. A content of the UV-absorbent in the master batch is not particularly restricted. However, a content of the UV-absorbent in the master batch is preferably selected so that a content of the UV-absorbent in the encapsulant for a photovoltaic module may be in the above-mentioned range.

### (3) Light Stabilizer

The light stabilizer used in the present invention will be explained next. The light stabilizer used in the invention is an agent for catching active species which initiate photo-deterioration in the encapsulant for a photovoltaic module and accordingly preventing photooxidation. Specifically, a light stabilizer such as hindered amine type compounds, hindered piperidine type compounds, and others can be used.

A content of a light stabilizer in an encapsulant for a photovoltaic module is, though depends on factors such as a particle shape and the density, preferably in the range of 0.1 to 0.4% by weight and more preferably in the range of 0.15 to 0.3% by weight. A content of the light stabilizer in the master batch is not particularly restricted. However, a content of the light stabilizer in the master batch is preferably selected so that a content of the light stabilizer in the encapsulant for a photovoltaic module may be in the above-mentioned range.

### (4) Thermal Stabilizer

Next, the thermal stabilizer used in the present invention will be explained. The thermal stabilizer used in the invention is to prevent oxidation degradation of the encapsulant for a photovoltaic module. Examples of the thermal stabilizer may include phosphorus type thermal stabilizers such as tris(2,4-di-tert-butylphenyl)phosphite, bis[2,4-bis(1,1-dimethylethyl)-6-methylphenyl]ethyl ester phosphite, tetrakis(2,4-di-tert-butylphenyl)[1,1-biphenyl]-4,4'-diyl bisphosphonite, and bis(2,4-di-tert-butylphenyl)pentaerythritol disphosphite; lactone type thermal stabilizers such as a reaction product of 8-hydroxy-5,7-di-tert-butyl-furan-2-one ando-xylene; a phenol based thermal stabilizer; an amine based thermal stabilizer; and a sulfur t based thermal stabilizer. One or more of them maybe used in combination. Among them, a phosphorus type thermal stabilizer and a lactone based thermal stabilizer may be used in combination.

A content of a thermal stabilizer in an encapsulant for a photovoltaic module is, though depends on factors such as a particle shape and the density, preferably in the range of 0.01 to 0.16% by weight and more preferably in the range of 0.01 to 0.17% by weight. A content of the thermal stabilizer in the master batch is not particularly restricted. However, a content of the thermal stabilizer in the master batch is preferably selected so that a content of the thermal stabilizer in the encapsulant for a photovoltaic module may be in the above-mentioned range.

In a method of measuring a content of the thermal stabilizer, after a pretreatment due to reflux and re-precipitation method, a qualitative analysis and a quantitative analysis are carried out. That is, (1) a solvent is added to an encapsulant for a photovoltaic module to carry out reflux extraction, and, thereby, a resin component and an additive component are dissolved. (2) To the dissolution solution, a poor solvent is added to precipitate a resin component, followed by filtering. (3) The filtrate is concentrated and, after measuring a volume, supplied as a sample solution. (4) The obtained sample solution is subj ected to the qualitative analysis and quantitative analysis. At this time, for the qualitative analysis, gas chromatograph/mass spectrometer (GC/MS) and high-performance liquid chromatograph/UV detector (HPLC/UVD) are used. For the quantitative analysis, gas chromatograph/hydrogen flame ionization detector (GC/FID) is used.

### 3. Encapsulant for Photovoltaic module

In the invention, the density of the encapsulant for a photovoltaic module is preferably in the range of about 0.895 to 0.910 g/cm³ and more preferably in the range of about 0.898 to 0.905 g/cm³. As mentioned above, in the invention, the respective densities of the polyethylene for polymerization and polyethylene for a master batch are in the predetermined ranges; accordingly, the density of the encapsulant for a photovoltaic module as a whole is preferably in the above-mentioned range.

The density is a value measured by means of a density gradient tube method defined by JIS K7112. Specifically, a sample is put in a test tube where liquids different in the specific gravity are accommodated, followed by reading a position where the sample stops, thereby the density is measured.

In the invention, when a encapsulant for a photovoltaic module is formed into a sheet set at 600 ± 15 µm, a peak area in a wavelength range of 6000 nm or more and 25000 nm or less is preferably 12000 or less and particularly preferably 10700 or less.
The peak area is obtained by measuring an infrared absorption spectrum from 6000 to 25000 nm by use of FT-IR610 (trade name, produced by JASCO Corporation) and by calculating a peak area from the obtained infrared absorption spectrum. In the invention, the peak area is calculated by use of a commercially available soft ware (Spectra Manager for Windows (registered trade mark) 95/NT Spectrum Analysis Version 1.500.00 [Build 8], produced by JASCO Corporation).

The encapsulant for a photovoltaic module is preferably high in the light transmittance. Specifically, the total light transmittance of the encapsulant for a photovoltaic module is preferably in the range of 70 to 100%, more preferably in the range of 80 to 100% and most preferably in the range of 90 to 100%. The total light transmittance is measured by means of an ordinary method, for example, amethodwherein a color computer is used to measure.

When the encapsulant for a photovoltaic module is formed in sheet, a thickness thereof is preferably in the range of 50 to 2000 µm and particularly preferably in the range of 100 to 1250 µm. This is because, when the thickness is thinner than the above range, the sheet cannot support a cell and the cell can be damaged easily. When the thickness is thicker than the above range, a module weight becomes heavy to be poor in the workability at the setting and also the cost becomes disadvantageous.
A method of producing an encapsulant for a photovoltaic module will be described in "C. Producing Method of Encapsulant for Photovoltaic module" below; accordingly the description is omitted here.

### B. Photovoltaic module

Next, a photovoltaic module of the invention will be described. A photovoltaic module of the invention has an encapsulant layer that uses the encapsulant for a photovoltaic module described above.

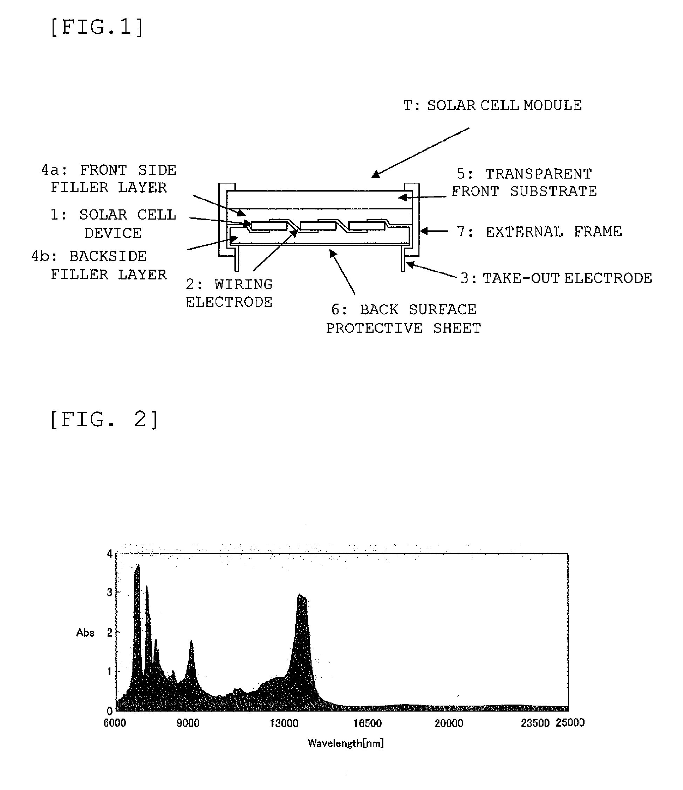

FIG. 1 is a schematic sectional view showing an example of a photovoltaic module of the invention. As exemplified in FIG. 1, a plurality of photovoltaic cell devices 1 is arranged in plane and, between photovoltaic cell devices 1, wiring electrodes 2 and take-out electrodes 3 are disposed. A photovoltaic cell device 1 is sandwiched by a front side encapsulant layer 4a and a backside encapsulant layer 4b. Outside of the front side encapsulant layer 4a a transparent front substrate 5 is laminated, and outside of the backside encapsulant layer 4b a back surface protective sheet 6 is laminated. The photovoltaic module T may be fixed by an external frame 7 of a material such as aluminum. In the invention, in at least one of the front side encapsulant layer 4a and backside encapsulant layer 4b, the encapsulant for photovoltaic module may be used. In particular, it is preferably used in the front side encapsulant layer 4a.

According to the invention, since the photovoltaic cell device has an encapsulant layer that uses the encapsulant for photovoltaic module mentioned above, a photovoltaic module having the foregoing advantages is obtained. Specifically, an encapsulant is inhibited from clouding caused by a temperature change due to the hot spot phenomenon or the like; accordingly, the appearance is inhibited from deteriorating.
In what follows, a configuration of a photovoltaic module of the invention will be described.

### 1. Encapsulant Layer

An encapsulant layer used in the invention uses an encapsulant described in "A. Encapsulant for Photovoltaic module". The encapsulant layer plays a role of adhering a photovoltaic cell device and a transparent front substrate or a back surface protective sheet; accordingly, it is preferred to be high in the adhesiveness with the transparent front substrate or the back surface protective sheet. Specifically, the peeling strength of the encapsulant layer off the transparent front substrate or back surface protective sheet, which is measured in a 180° peel test under a 25°C atmosphere, is preferably in the range of 1 to 150 N/15 mm width, more preferably in the range of 3 to 150 N/15 mm width and most preferably in the range of 10 to 150 N/15 mm width.

The peel strength is a value obtained by a test method below.
Test machine: Tensile tester (trade name: TENSILON^{®}, produced by A & D CO., Ltd.)
Measurement angle: 180° peeling
Peeling rate: 50 mm/min

Furthermore, the encapsulant layer is preferred to retain the adhesiveness over a long time. That is, the peel strength of the encapsulant layer off the transparent front substrate or back surface protective sheet, which is measured in a 180° peel test under a 25°C atmosphere after a photovoltaic module is left in a high temperature and high humidity state of a temperature of 85°C and humidity of 85% for 1000 hours, is preferably in the range of 0.5 to 140 N/15 mm width, more preferably in the range of 3 to 140 N/15 mm width and most preferably in the range of 10 to 140 N/15 mm width. The measurement method is similar to that mentioned above.

A thickness of the encapsulant layer is preferably in the range of 50 to 2000 µm and particularly preferably in the range of 100 to 1250 µm. When the thickness of the encapsulant layer is thinner than the above range, the encapsulant layer cannot support the cell, and the cell can be easily damaged. When the thickness is thicker than the above range, a module weight becomes heavy to be poor in the workability at the setting and also the cost becomes disadvantageous.

### 2. Photovoltaic cell Device

A photovoltaic cell device used in the invention is not particularly restricted as far as it has a function as a photovoltaic power generator. One that is generally used as a photovoltaic cell device maybe used. Examples thereof include crystalline silicon photovoltaic cell devices such as a single crystal silicon photovoltaic cell device and a polycrystalline silicon photovoltaic cell device, amorphous silicon photovoltaic cell devices made of single connection type or tandem structure type, photovoltaic cell devices of III-V group compound semiconductors such as gallium arsenide (GaAs) and indium phosphide (InP) and photovoltaic cell devices of II-VI group compound semiconductors such as cadmium telluride (CdTe) and copper indium selenide (CuInSe₂). Furthermore, hybrid devices of a thin filmpolycrystalline silicon photovoltaic cell device, a thin film microcrystalline silicon photovoltaic cell device or a thin film crystalline silicon photovoltaic cell device and an amorphous silicon photovoltaic cell device as well are used.

The photovoltaic cell devices are configured by forming, on a substrate such as a glass substrate, a plastic substrate and a metal substrate, a photovoltaic portion such as crystalline silicon having a pn junction structure, amorphous silicon having a p-i-n junction structure and a compound semiconductor.

In a photovoltaic module of the invention, as shown in FIG. 1, a plurality of photovoltaic cell devices 1 is arranged. When the photovoltaic cell 1 is illuminated by sun light, electrons (-) and holes (+) are generated, and a current is flowed by a wiring electrode 2 and a take-out electrode 3 that are disposed between photovoltaic cell devices.

### 3. Transparent Front Substrate

In the invention, a transparent front substrate has a function of protecting the inside of a module from weather, external impact and fire to secure the long term reliability of a photovoltaic module in the outdoor exposure.
Such a transparent front substrate is not restricted to particular one as far as it has the transmittance to sun light and the electric insulating property and is excellent in mechanical, chemical or physical properties. One that is generally used as a transparent front substrate for a photovoltaic module may be used. Examples thereof include a glassplate, a fluorinated resin sheet, a cyclic polyolefin based resin sheet, a polycarbonate based resin sheet, a poly (meth) acrylate based resin sheet, a polyamide based resin sheet and a polyester based resin sheet. Among these, a glass plate is preferably used as the transparent front substrate in the invention. This is because the glass substrate is excellent in the heat resistance and, thereby, a heating temperature is set sufficiently high when the respective constituent members are separated from a used photovoltaic module and a front side encapsulant adhered to a surface of the glass plate is removed; accordingly, reuse or recycle is readily realized.

### 4. Back surface protective sheet

A back surface protective sheet is a weather-resistant film that protects a back surface of a photovoltaic module from the exterior. Examples of the back surface protective sheets used in the invention include a plate or a foil of metal such as aluminum, a fluorinated resin sheet, a cyclic polyolefin based resin sheet, a polycarbonate based resin sheet, a poly (meth) acrylate based resin sheet, a polyamide based resin sheet and a polyester based resin sheet and a composite sheet obtained by laminating a weather-resistant film and a barrier film.
A thickness of the back surface protective sheet used in the invention is preferably in the range of 20 to 500 µm and more preferably in the range of 60 to 350 µm.

### 5. Other Constituent Members

In the invention, other than the above, in view of the absorptivity of sun light, reinforcement and other obj ects, other layers may be further arbitrarily added and laminated.
Furthermore, after the respective constituent members are laminated, in order to fix the respective layers in one integrated body, an external frame may be disposed. As the external frame, one same as a material used in the back surface protective sheet may be used.

### 6. Producing Method of Photovoltaic module

A producing method of the invention of a photovoltaic module is not restricted to particular one. A method that is generally used as a producing method of a photovoltaic module may be used. For instance, a method where an ordinary molding method such as a lamination method is used and the respective constituent members are molded under heating and pressure as one integrated body is cited. In the lamination method, constituent members such as a transparent front substrate, an encapsulant for a photovoltaic module, a photovoltaic cell device, an encapsulant for a photovoltaic module and a back surface protective sheet are faced and laminated in this order, other constituent members are laminated as needed, integrated by vacuum suctioning, and pressure bonded under heating.

In the invention, a lamination temperature when such lamination method is applied is preferably in the range of 90 to 230°C and more preferably in the range of 110 to 190°C. When a temperature is lower than the above range, sufficient melting is not obtained, and, in some cases, the adhesiveness with the transparent front substrate, an auxiliary electrode, the photovoltaic cell device and the back surface protective sheet may be deteriorated.

A lamination time is preferably in the range of 5 to 60 minutes andparticularlypreferably in the range of 8 to 4 0 minutes . When the lamination time is too short, sufficient melting is not achieved and, in some cases, the adhesiveness with the respective constituent members is deteriorated. On the other hand, when the lamination time is too long, a process-related problem may be caused.
An external frame for fastening an integrally molded body obtained by laminating the respective constituent members may be attached after the respective constituent members are laminated and before pressure bonding is applied under heating. Alternatively, it may be attached after pressure bonding is applied under heating.

### C. Producing Method of Encapsulant for Photovoltaic module

A producing method of an encapsulant for a photovoltaic module of the invention will be described next. The producing method of an encapsulant for a photovoltaic module of the invention comprises a process of heating and melting a master batch into resin for encapsulant, wherein the resin for encapsulant containing a silane-modified resin obtained by polymerizing an ethylenically unsaturated silane compound and polyethylene for polymerization that has the density in the range of 0.895 to 0.910 g/cm³ and that is metallocene based linear low density polyethylene; and the master batch containing a UV-absorbent, a light stabilizer, a thermal stabilizer and master batch for use in a polyethylene that has the density in the range of 0.895 to 0.910 g/cm³ and that is metallocene based linear low density polyethylene are heated and melted.

Conventionally, when a master batch is prepared, in order to make the dispersing properties of the additives such as the thermal stabilizer excellent, in many cases, the additives and polyethylene powder obtained by pulverizing polyethylene for use in a master batch are mixed and polyethylene relatively high in the density is mainly used at the time. This is because the high density polyethylene is readily pulverized so that it is excellent in the workability and it realizes low cost. However, the high density polyethylene is disadvantageous in being easily crystallized, and thereby resulting in causing the clouding of the encapsulant.
According to the invention, the density of the polyethylene for use in a master batch is relatively low; accordingly, even when the hot spot phenomenon or the like causes a temperature change, polyethylene is inhibited from crystallizing, resulting in inhibiting the encapsulant from clouding. Accordingly, an encapsulant for a photovoltaic module, which is difficult to cause the clouding due to the temperature change is produced.
In what follows, a producing method of an encapsulant for a photovoltaic module of the invention will be described for each of configurations.

### 1. Resin for Encapsulant

A resin for an encapsulant used in the invention contains:
a silane-modified resin obtained by polymerizing an ethylenically unsaturatedsilane compound, and polyethylene for polymerization that has the density in the range of 0.895 to 0.910 g/cm³ and that is metallocene based linear low density polyethylene. Such resin for encapsulant is same as that described in "A. Encapsulant for Photovoltaic module"; accordingly, the description here will be omitted.

### 2. Master Batch

The master batch used in the invention contains a UV-absorbent, a light stabilizer, a thermal stabilizer and master batch polyethylene that has the density in the range of 0.895 to 0.910 g/cm³ and that is metallocene based linear low density polyethylene. Such master batch is same as that described in "A. Encapsulant for Photovoltaic module"; accordingly, the description here will be omitted.

### 3. Preparing Method of Encapsulant for Photovoltaic module

Next, a preparing method of an encapsulant for a photovoltaic module will be described. In the invention, by executing a process where the master batch is heated and melted in the resin for encapsulant, an encapsulant for a photovoltaic module is prepared.
At this time, the resin for encapsulant including polyethylene for addition and the master batch may be heated and melted, or a resin for encapsulant that does not contain polyethylene for addition, the polyethylene for addition and the master batch may be heated and melted.

Furthermore, a heating and melting method thereof is not particularly restricted. Heating temperature is preferably 300°C or less, more preferably 270°C or less and most preferably 230°C or less. In the invention, after heating and melting, the encapsulant for photovoltaic module may be formed into a sheet. In this case, after heating and melting, an existing method such as a T die method or an inflation method may be used.

While the invention has been described with reference to specific embodiments, the description is illustrative of the invention and is not to be construed as limiting the invention. It is therefore intended that the technical scope of the invention encompass any modifications which comprise the construction substantially equal to the technical idea as defined by the appended claims and have the same effect.

### EXAMPLES

Hereinafter, the invention will be described further in detail with reference to examples and comparative examples.

### [Example 1]

### (Preparation of Silane-modified Resin)

In the beginning, to 100 parts by weight of metallocene based linear low density polyethylene having the density of 0.898 g/cm³, 2.5 parts by weight of vinyltrimethoxy silane and 0.1 part by weight of dicumyl peroxide as a radical initiator (reactive catalyst) were mixed, followed by melting and kneading at 200°C, thereby, a silane-modified resin was obtained.

### (Preparation of Master Batch)

To 100 parts by weight of powder obtained by pulverizing metallocene linear low density polyethylene having the density of 0.900 g/cm³, 3.75 parts by weight of a benzotriazole based UV-absorbent, 5 parts by weight of a hindered amine based light stabilizer and 0.5 part by weight of phosphorus based thermal stabilizer were mixed, followed by melting and processing, thereby a pelletized master batch was obtained.

### (Preparation of Encapsulant for Photovoltaic module)

To 20 parts by weight of the silane-modified resin, 5 parts by weight of the master batch and 80 parts by weight of metallocene linear low density polyethylene having the density of 0.905 g/cm³ as the polyethylene for addition were mixed and, by use of a film molding machine having a φ150 mm extruder and a 1000 mm width T dice, at an extrusion temperature of 230°C and a take off speed of 2.3 m/minute, an encapsulant for a photovoltaic module having a total thickness of 600 µm was prepared.

### (Preparation of Photovoltaic module)

A glass plate (transparent front substrate) having a thickness of 3 mm, an encapsulant for a photovoltaic module having a thickness of 600 µm, a photovoltaic cell device made of polycrystalline silicon, an encapsulant for a photovoltaic module having a thickness of 600 µm, a polyfluorinated vinyl based resin sheet (PVF) having a thickness of 38 µm, and a laminate sheet (back surface protective sheet) made of a polyethylene terephthalate sheet having a thickness of 30 µm and a polyfluorinated vinyl based resin sheet (PVF) having a thickness of 38 µm are laminated in this order, followed by, with a surface of a photovoltaic cell device directed upward, pressure bonding in a vacuum laminator for use in production of a photovoltaic module at 150°C for 15 minutes, thereby a photovoltaic module was prepared.

### [Example 2]

### (Preparation of Master Batch)

To 30 parts by weight of powder obtained by pulverizing metallocene linear low density polyethylene having the density of 0.898 g/cm³, 70 parts by weight of metallocene linear low density polyethylene having the density of 0.900 g/cm3, 7 parts by weight of a benzotriazole based UV-absorbent, 10 parts by weight of a hindered amine based light stabilizer and 1 part by weight of phosphorus based thermal stabilizer were mixed, followed by melting and processing, thereby a pelletized master batch was obtained.

### (Preparation of Encapsulant for Photovoltaic module)

To 40 parts by weight of silane-modified resin used in Example 1, 5 parts by weight of the master batch and 60 parts by weight of metallocene based linear low density polyethylene having the density of 0.900 g/cm³ as the polyethylene for addition were mixed and, according to a method similar to that of Example 1, an encapsulant for photovoltaic module was prepared.
Furthermore, according to a method similar to that of Example 1, a photovoltaic module was prepared.

### [Example 3]

### (Preparation of Master Batch)

To 100 parts by weight of powder obtained by pulverizing metallocene linear low density polyethylene having the density of 0.896 g/cm³, 3.75 parts by weight of a benzotriazole based UV-absorbent, 2.5 parts by weight of a hindered amine based light stabilizer and 0.25 part by weight of phosphorus based thermal stabilizer were mixed, followed by melting and processing, thereby a pelletized master batch was obtained.

### (Preparation of Encapsulant for Photovoltaic module)

To 10 parts by weight of silane-modified resin used in example 1, 5 parts by weight of the master batch and 90 parts by weight of metallocene based linear low density polyethylene having the density of 0.900 g/cm³ as the polyethylene for addition were mixed and, according to a method similar to that of example 1, an encapsulant for photovoltaic module was prepared.
Furthermore, according to a method similar to that of Example 1, a photovoltaic module was prepared.

### [Example 4]

### (Preparation of Silane-modified Resin)

In the beginning, to 100 parts by weight of metallocene based linear low density polyethylene having the density of 0.896 g/cm³, 2.5 parts by weight of vinyltrimethoxy silane and 0.1 part by weight of dicumyl peroxide as a radical initiator (reactive catalyst) were mixed, followed by melting and kneading at 200°C, thereby, a silane-modified resin was obtained.

### (Preparation of Master Batch)

To 100 parts by weight of powder obtained by pulverizing metallocene linear low density polyethylene having the density of 0.904 g/cm³, 1.88 parts by weight of a benzotriazole based UV-absorbent, 10 parts by weight of a hindered amine based light stabilizer and 0.5 part by weight of phosphorus based thermal stabilizer were mixed, followed by melting and processing, thereby a pelletized master batch was obtained.

### (Preparation of Encapsulant for Photovoltaic module)

To 20 parts by weight of the silane-modified resin, 5 parts by weight of the master batch and 80 parts by weight of metallocene linear low density polyethylene having the density of 0.898 g/cm³ as the polyethylene for addition were mixed and, an encapsulant for a photovoltaic module was prepared by the similar method to that of Example 1.
Furthermore, according to a method similar to that of Example 1, a photovoltaic module was prepared.

### [Example 5]

### (Preparation of Silane-modified Resin)

In the beginning, to 100 parts by weight of metallocene based linear low density polyethylene having the density of 0.904 g/cm³, 2.5 parts by weight of vinyltrimethoxy silane and 0.1 part by weight of dicumyl peroxide as a radical initiator (reactive catalyst) were mixed, followed by melting and kneading at 200°C, thereby, a silane-modified resin was obtained.

### (Preparation of Master Batch)

To 100 parts by weight of powder obtained by pulverizing metallocene linear low density polyethylene having the density of 0.896 g/cm³, 3.75 parts by weight of a benzotriazole based UV-absorbent, 20 parts by weight of a hindered amine based light stabilizer and 0.5 part by weight of phosphorus based thermal stabilizer were mixed, followed by melting and processing, thereby a pelletized master batch was obtained.

### (Preparation of Encapsulant for Photovoltaic module)

To 20 parts by weight of the silane-modified resin, 5 parts by weight of the master batch and 80 parts by weight of metallocene linear low density polyethylene having the density of 0.898 g/cm³ as the polyethylene for addition were mixed and, an encapsulant for a photovoltaic module was prepared by the similar method to that of Example 1.
Furthermore, according to a method similar to that of Example 1, a photovoltaic module was prepared.

### [Comparative Example 1]

### (Preparation of Master Batch)

To 100 parts by weight of powder obtained by pulverizing medium density polyethylene having the density of 0.940 g/cm³, 3.75 parts by weight of a benzotriazole based UV-absorbent, 10 parts by weight of a hindered amine based light stabilizer and 1 part by weight of phosphorus based thermal stabilizer were mixed, followed by melting and processing, thereby a pelletized master batch was obtained.

### (Preparation of Encapsulant for Photovoltaic module)

To 100 parts by weight of the silane-modified resin used in Example 1, 5 parts by weight of the master batch and 90 parts by weight of metallocene based linear low density polyethylene having the density of 0 . 900 g/cm³ as the polyethylene for addition were mixed and, according to a method similar to that of Example 1, an encapsulant for photovoltaic module was prepared.
Furthermore, according to a method similar to that of Example 1, a photovoltaic module was prepared.

### [Comparative Example 2]

### (Preparation of Master Batch)

To 100 parts by weight of powder obtained by pulverizing Ziegler catalyst based linear low density polyethylene having the density of 0.910 g/cm³, 3.75 parts by weight of a benzotriazole based UV-absorbent, 5 parts by weight of a hindered amine based light stabilizer and 0.5 part by weight of phosphorus based thermal stabilizerweremixed, followed by melting and processing, thereby a pelletized master batch was obtained.

### (Preparation of Encapsulant for Photovoltaic module)

To 10 parts by weight of the silane-modified resin used in Example 1, 5 parts by weight of the weather resistant agent master batch and 90 parts by weight of metallocene based linear low density polyethylene having the density of 0.900 g/cm³ as the polyethylene for addition were mixed and, according to a method similar to that of Example 1, an encapsulant for photovoltaic module was prepared.
Furthermore, according to a method similar to that of Example 1, a photovoltaic module was prepared.

### [Comparative Example 3]

### (Preparation of Encapsulant for Photovoltaic module)

According to a method similar to that of Example 1, a master batch was prepared.
To 20 parts by weight of the silane-modified resin used in Example 1, 5 parts by weight of the master batch and 80 parts by weight of an ethylene-vinyl acetate copolymer resin (EVA) containing 12% by weight of vinyl acetate (VA) were mixed and, according to a method similar to that of Example 1, an encapsulant for photovoltaic module was prepared.
Furthermore, according to a method similar to that of Example 1, a photovoltaic module was prepared.

### [Comparative Example 4]

### (Preparation of Photovoltaic module)

a photovoltaic module was prepared according to a method similar to Example 1, except that a commercially available EVA sheet for photovoltaic module (thickness: 600 µm) was used in place of the encapsulant for photovoltaic module of Example 1, and that the resultant was used to pressure bonded in a vacuum laminator at 150°C for 5 minutes and subsequently was left in an oven held at 150°C for 30 minutes.

### [Evaluation of Characteristics]

Regarding encapsulants for photovoltaic module and photovoltaic modules obtained in Examples 1 through 5 and Comparative Examples 1 through 4, tests as below were carried out. Measurements of the respective tests are shown in Table 1.

### (1) Measurement of Haze

### (Leaving at Room Temperature)

Regarding each encapsulant for photovoltaic module the respective haze (%) was measured by use of a SM color computer (trade name: SM-C, produced by Suga Test Instruments Co., Ltd). Specifically, each encapsulant for photovoltaic module was sandwiched by a blue float glass having the total transmittance of front and back of 91%, the haze of 0.2% and a thickness of 3 mm from front and back, followed by pressure bonding at 150°C for 15 minutes by use of a vacuum laminator for use in production of photovoltaic modules, further followed by leaving at room temperature (25°C) to cool, thereby a sample for haze test was prepared. The haze was measured regarding these samples.

### (Quenching)

Each of the samples for haze measurement was put in an oven set at 150°C for 1 hour, taken out, followed by instantaneously thrown in a refrigerator set at -20°C and leaving there for 10 minutes. The sample was taken out of the refrigerator, left at room temperature (25°C), and, when a sample temperature became room temperature, the haze was measured by use of a SM color computer (trade name: SM-C, produced by Suga Test Instrument Co. Ltd).

### (Gradual Cooling)

Each of the samples for haze measurement was put in an oven set at 150°C for 1 hour, followed by gradually lowering a preset temperature of the oven at a cooling speed of 1°C/minute to room temperature (25°C). Thereafter, the haze was measured by use of a SM color computer (trade name: SM-C, produced by Suga Test Instrument Co. Ltd).

### (2) Measurement of Adhesiveness

After a photovoltaic module is produced, the peel strength (N/15 mm width) between an encapsulant layer for photovoltaic module and a transparent front substrate was measured under room temperature (25°C).

### (3) Hot Spot Test

Regarding each photovoltaic module, the hot spot test was carried out based on JIS C8917, followed by evaluating the appearance thereafter.

### (4) Peak Area

By use of FT-IR610 (trade name, produced by JASCO Corporation), an infrared absorption spectrum from 6000 nm to 25000 nm was measured according to infrared spectrometry, and a peak area was calculated from obtained infrared absorption spectrum. As an example, an infrared absorption spectrum of Example 1 is shown in FIG. 2. A shaded portion is an obtained peak area.

### (5) Temperature of Photovoltaic module

Each photovoltaic module was set on an outdoor rack well sun-shined, exposed under conditions of an ambient temperature of about 32°C for 1 hour, followed by measuring a temperature of the photovoltaic module.

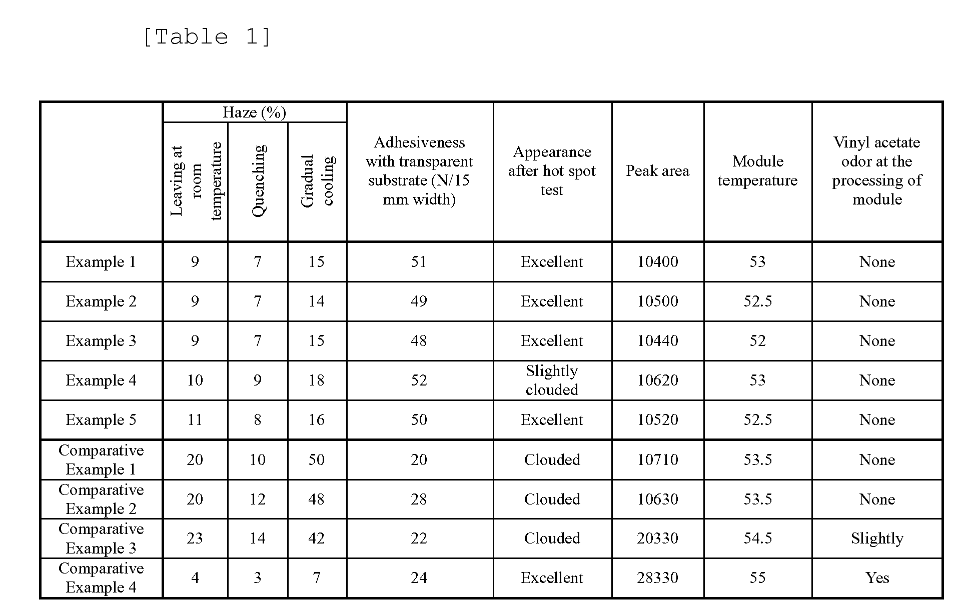

As apparent from Table 1, the encapsulants for photovoltaic module obtained in Examples 1 through 5 had less difference in the haze which was caused by difference in the cooling speed, and they were not easily clouded after the hot spot test. Furthermore, it was confirmed that the respective peak areas was small and the heat ray was absorbed less therein. It was also confirmed that, at the time of outdoor exposure, respective temperature of the photovoltaic module was low.
In contrast thereto, in encapsulants for photovoltaic module obtained in Comparative Examples 1 through 4, the respective haze was largely different depending on the cooling speed and the clouding was caused thereto owing to the hot spot test. Furthermore, it was confirmed that, in the encapsulants for photovoltaic module obtained in Comparative Examples 3 and 4, the respective peak area was large and absorption of the heat line therein was high. It was also confirmed that respective temperature of a photovoltaic module at the time of outdoor exposure was high.
The above-mentioned advantages are found in other configurations as well irrespective of the configurations of the transparent front substrates and back surface protective sheets cited in the Examples and Comparative Examples.

## Claims

1. An encapsulant for a photovoltaic module comprising:
a resin for an encapsulant containing a silane-modified resin obtained by polymerizing an ethylenically unsaturated silane compound and polyethylene for polymerization; and
a master batch containing a UV-absorbent, a light stabilizer, a thermal stabilizer and polyethylene for use in a master batch,
**characterized in that** the polyethylene for polymerization and the polyethylene for use in a master batch are metallocene based linear low density polyethylene having a density in the range of 0.895 g/cm³ to 0.910 g/cm³.

2. The encapsulant for a photovoltaic module according to claim 1, **characterized in that**, when the encapsulant for a photovoltaic module is formed into a sheet having a thickness set at 600 ± 15 µm, a peak area in the range of a wavelength of 6000 nm or more and 25000 nm or less is 12000 or less.

3. A photovoltaic module comprising an encapsulant layer using the encapsulant for a photovoltaic module according to claim 1 or 2.
